# EUROPEAN PATENT APPLICATION

(11) **EP 2 355 545 A1**
(43) Date of publication of application: **10.08.2011**
(21) Application number: 10007838.5
(22) Date of filing: 28.07.2010
(51) Int. Cl.: H04R 17/00, H04R 31/00

(54) **Electrode connector and film speaker**

(30) Priority: 14.12.2009 KR 20090124005
(71) Applicant: Fils Co., Ltd., Jungwon-gu Seongnam-si, Gyeonggi-do 462-120 (KR)
(72) Inventor: Lee, Dong Soo, Seongnam-si, Gyeonggi-do 462-711 (KR); Park, In Suk, Seongnam-si, Gyeonggi-do 462-711 (KR); Jo, Sung Ik, Seongnam-si Gyeonggi-do, 463-817 (KR)
(74) Representative: Dr. Weitzel & Partner

(57) **Abstract**

An electrode connector for use in a film speaker is provided, which includes a Y-shaped substrate including a first end portion, a second end portion, and a common end portion; a first interconnection formed on the first end portion and the common end portion; and a second interconnection formed on the second end portion and the common end portion. The first interconnection is connected to an upper electrode and an electric signal input portion of the film speaker, and the second interconnection is connected to a lower electrode and the electric signal input portion of the film speaker.

## Description

### BACKGROUND OF THE INVENTION

### Field of the invention

The present invention relates to an electrode connector and a film speaker including the electrode connector.

### Description of the Prior Art

With the trend of miniaturization and thin film formation of home appliances, film speakers using piezoelectric elements have been developed in place of the existing speakers. A film speaker is manufactured using a piezoelectric film, which is obtained by applying plasma to PVDF (Poly Vinylidene Fluoride) or other resin film so that the film has the hydrophilic property and coating the film with a conductive material.

If an audio signal is applied to such a film speaker, a piezoelectric film of the film speaker oscillates to generate sound. In order to apply an audio signal to the film speaker, specified electrode connectors should be provided on electrodes which are on upper and lower portions of the piezoelectric film, and if necessary, an amplifier that amplifies the audio signal and a matching transformer may be additionally provided.

Also, in the film speaker, the electrode connectors are for the purpose of reliably transferring the audio signal to the upper electrode and the lower electrode of the film speaker, and metal terminals having superior conductivity are mainly used as the electrode connectors. The electrode connectors, in order to transfer the audio signal to the electrodes on the piezoelectric film, are fixed to the piezoelectric film by a conductive tape (e.g. copper tape), ACF, conductive adhesives, rivets, and the like.

However, in order to maintain the connection reliability, the ACF and the conductive adhesives require separate physical fastening devices and high temperature curing, and thus their use is restricted. In the case of the rivets, there is a limit in reducing the height of the film speaker.

Also, in the case where the conductive tape is attached to the upper electrode and the lower electrode of the film speaker and is connected to wires for signal transmission by soldering, there is a problem that the conductive tape is easily down or the soldered portion comes off.

### SUMMARY OF THE INVENTION

Accordingly, the present invention has been made to solve the above-mentioned problems occurring in the prior art while advantages achieved by the prior art are maintained intact.

One subject to be achieved by the invention is to provide an electrode connector and a film speaker, which can make it possible to efficiently connect one Y-shaped electrode connector to an upper electrode and a lower electrode of the film speaker.

Another subject to be achieved by the invention is to provide an electrode connector and a film speaker, which can easily reduce the height of components, and heighten the effects of reduction of the terminal process stage and the manufacturing cost through the Y-shaped electrode connector composed of an FPCB (Flexible Printed Circuit Board) which is not easily disconnected and has a high flexibility.

Still another subject to be achieved by the invention is to provide an electrode connector and a film speaker, which can achieve a good flow of electric signals by forming a coating layer on upper and lower layers of a first end portion and a second end portion of the Y-shaped electrode connector and making the first end portion and the second end portion efficiently come into close contact with a lower electrode and an upper electrode of the film speaker.

Further still another subject to be achieved by the invention is to provide an electrode connector and a film speaker, which can make the electrode connector fixed to an upper electrode and a lower electrode of the film speaker more effectively by spreading adhesives on at least one of a lower surface of a first end portion and an upper surface of a second end portion of the Y-shaped electrode connector.

In one aspect of the present invention, there is provided an electrode connector for use in a film speaker, which includes a Y-shaped substrate including a first end portion, a second end portion, and a common end portion; a first interconnection formed on the first end portion and the common end portion; and a second interconnection formed on the second end portion and the common end portion; wherein the first interconnection is connected to an upper electrode and an electric signal input portion of the film speaker, and the second interconnection is connected to a lower electrode and the electric signal input portion of the film speaker.

In another aspect of the present invention, there is provided a film speaker, which includes a piezoelectric film; upper and lower conductive films formed on upper and lower surfaces of the piezoelectric film, respectively; upper and lower electrodes formed to extend along edges of the upper and lower conductive films, respectively; and a connector connected to the upper and lower electrodes; wherein the connector includes a Y-shaped substrate including a first end portion, a second end portion, and a common end portion; a first interconnection formed on the first end portion and the common end portion; and a second interconnection formed on the second end portion and the common end portion; wherein the first interconnection is connected to the upper electrode and an electric signal input portion of the film speaker, and the second interconnection is connected to the lower electrode and the electric signal input portion of the film speaker.

The electrode connector and the film speaker according to an embodiment of the invention have the following advantages.

First, it is possible to efficiently connect one Y-shaped electrode connector to the upper electrode and the lower electrode of the film speaker.

Second, the height of components can be easily reduced and effects of reduction of the terminal process stage and the manufacturing cost can be heightened through the Y-shaped electrode connector composed of an FPCB (Flexible Printed Circuit Board) which is not easily disconnected and has a high flexibility.

Third, a good flow of electric signals can be achieved by forming a coating layer on upper and lower layers of a first end portion and a second end portion of the Y-shaped electrode connector and making the first end portion and the second end portion efficiently come into close contact with a lower electrode and an upper electrode of the film speaker.

Fourth, the electrode connector can be fixed to a flexible member more effectively by spreading adhesives on at least one of a lower surface of a first end portion and an upper surface of a second end portion of the Y-shaped electrode connector.

### BRIEF DESCRIPTION OF THE DRAWINGS

The above and other objects, features and advantages of the present invention will be more apparent from the following detailed description taken in conjunction with the accompanying drawings, in which:
FIGS. 1A to 1C are front views of a film speaker according to an embodiment of the invention;
FIG. 2 is a sectional view of the film speaker of FIG. 1;
FIGS. 3A to 3C illustrate shapes of an electrode connector according to an embodiment of the invention; and
FIGS. 4A to 4C illustrate shapes of an electrode connector according to another embodiment of the invention.

### DETAILED DESCRIPTION OF THE PREFERRED EMBODIMENTS

Hereinafter, preferred embodiments of the present invention will be described with reference to the accompanying drawings. The matters defined in the description, such as the detailed construction and elements, are nothing but specific details provided to assist those of ordinary skill in the art in a comprehensive understanding of the invention, and the present invention is only defined within the scope of the appended claims. In the entire description of the invention, the same reference numerals are used for the same elements across various figures.

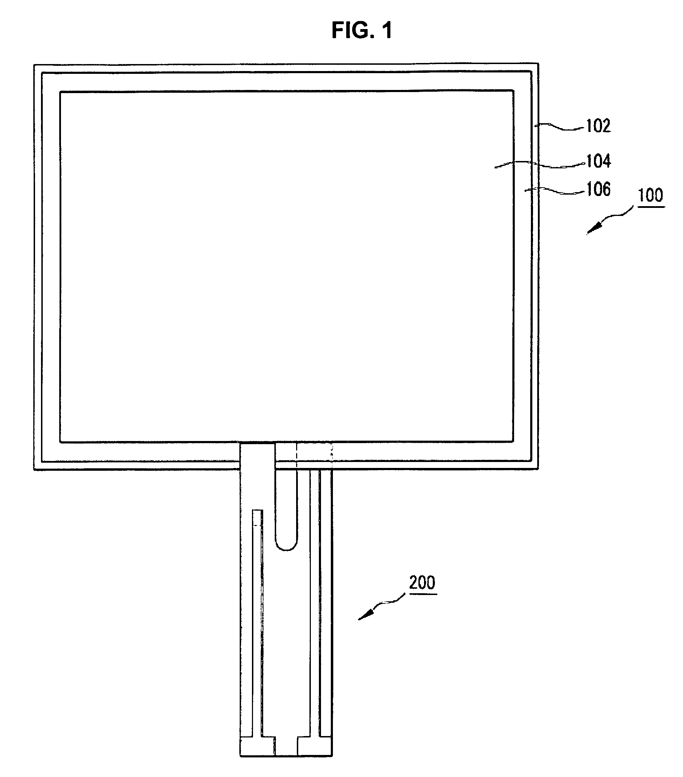

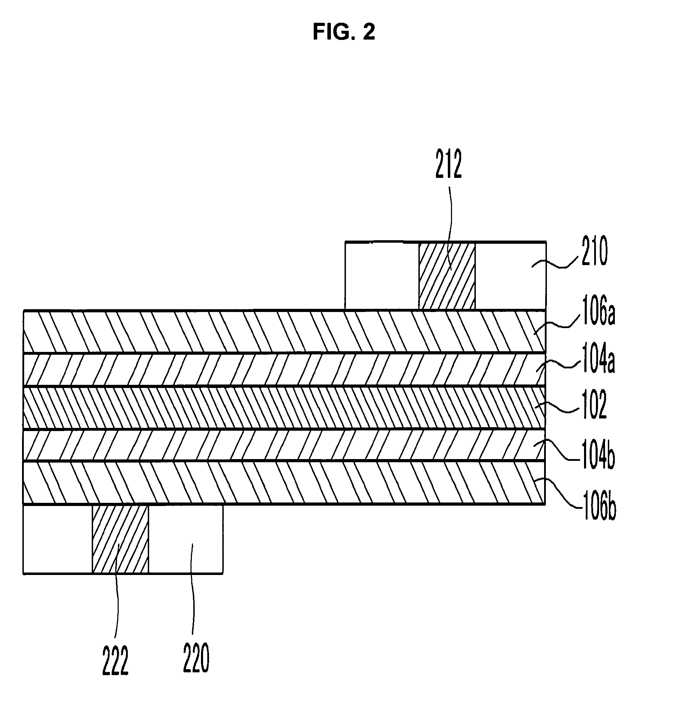

FIGS. 1A to 1C are front views of a film speaker 100 according to an embodiment of the invention, and FIG. 2 is a sectional view of the film speaker 100 of FIG. 1.

As illustrated in FIGS. 1A to 1C and 2, the film speaker 100 includes a piezoelectric film 102, upper and lower conductive films 104a and 104b formed on upper and lower surfaces of the piezoelectric film 102, respectively, as conductive films 104, upper and lower electrodes 106a and 106b formed to extend along edges of the upper and lower conductive films 104a and 104b, respectively, as electrodes 106, and an electrode connector 200 connected to the upper and lower electrodes 106a and 106b.

The piezoelectric film 102 mechanically oscillates according to an input voltage and outputs sound corresponding to the voltage. The piezoelectric film 102 uses an inverse piezoelectric effect phenomenon of a piezoelectric element. According to the inverse piezoelectric effect phenomenon, if a high-frequency voltage is applied to a crystalline plate having the piezoelectric property, the plate periodically expands and contracts, and in this case, by matching the frequency of the voltage to the natural frequency of the plate, the plate oscillates strongly through resonance to generate sound.

Here, as the piezoelectric film 102, for example, a PVDF (Poly Vinylidene Fluoride) film may be used. Since the piezoelectric film 102 is well known in the art, the detailed explanation thereof will be omitted.

The conductive film 104 supplies a voltage to the piezoelectric film 102. The conductive film 104, for example, may be formed of conductive polymers, and due to this characteristic, externally applied voltage can be uniformly supplied to the entire piezoelectric film 102.

In this case, the conductive film 104 may be formed on both surfaces of the piezoelectric film 102, for example, by spreading conductive polymers. That is, two conductive films 104 are formed, and one conductive film 104 is connected to an anode of the power, while the other conductive film 104 is connected a cathode of the power. Accordingly, electric potential is formed between both the conductive films and a voltage can be supplied to the piezoelectric film 102.

Also, the conductive film 104 may be formed on the inside of the piezoelectric film 102 to be apart for a predetermined distance from the edge of the piezoelectric film 102. That is, by spreading conductive polymers on the inside of the piezoelectric film 102 to be apart for a predetermined distance from the edge of the piezoelectric film 102, the conductive film 104 is formed in a manner that the piezoelectric film 102 on which the conductive film 104 is not formed surrounds the edge of the piezoelectric film 102 on which the conductive film 104 is formed.

If the conductive film 104 is formed as described above, the piezoelectric film 102 on which the conductive film 104 is formed oscillates by the applied voltage, but the piezoelectric film 102 on which the conductive film 104 is not formed does not receives the voltage and thus does not oscillate.

Accordingly, the piezoelectric film 102 on which the conductive film 104 is not formed serves as the edge of the piezoelectric film 102 on which the conductive film 104 is formed, and thus the sound break is prevented from occurring at the edge portion of the piezoelectric film 102.

The electrode 106 supplies the power to the conductive film 104. The electrode 106, for example, may be formed by printing silver paste or conductive mixed ink along the edge of the conductive film 104.

In this case, the silver paste that is used as the electrode 106, for example, is composed by mixing 40% of organic binder (solvent and additives) and 60% of silver powder. Hereinafter, Table 1 is an example of a table for specification of silver powder, and Table 2 is an example of a table for specification of the composed silver paste.

**[Table 1]**

| Classification | Remarks |
|---|---|
| Silver Powder Formation | Flake Type |
| Specific Surface Area (m²/g) | 0.7∼1.3 |
| Tap Density (g/cc) | 2.9∼3.9 |

**[Table 2]**

| Classification | Remarks |
|---|---|
| Viscosity | 10,000±500CPS(Brook Filed 4Spindle*30rpm*25°c) |
| Solids | 60∼70% |
| Attachment Force | 100/100 |
| Surface Resistance | 0.3 or lower (Ω/cm²) (Print Thickness: 5∼10 µm) |
| Specific Gravity | 3∼7 |

As shown in Table 2, the silver paste that forms the electrode 106 can be in completely close contact with the conductive film 104. Also, the silver paste has a small surface resistance, and thus less noise is generated.

On the other hand, Table 3 is a table for specification of the conductive mixed ink to form the electrode 106, and the electrode is composed using a conductive mixed ink or silver paste of silver component.

**[Table 3]**

| Classification | Remarks |
|---|---|
| External Appearance | Dark Brown (Visual Test) |
| Viscosity | 800∼900cps(25°c, 50rpm) |
| Thixotropic Index | 5.5∼6.5(25°c, 5rpm/50rpm) |
| Attachment Force | 100/100 (After cross-out at intervals of 1 mm, OPP adhesive tape is attached and then detached, and the remaining figures are inscribed) |
| Volume Resistance | 0.4*10⁻⁴ or lower Ω/cm² (Measurement with width of 0.7 mm and length of 2m) |

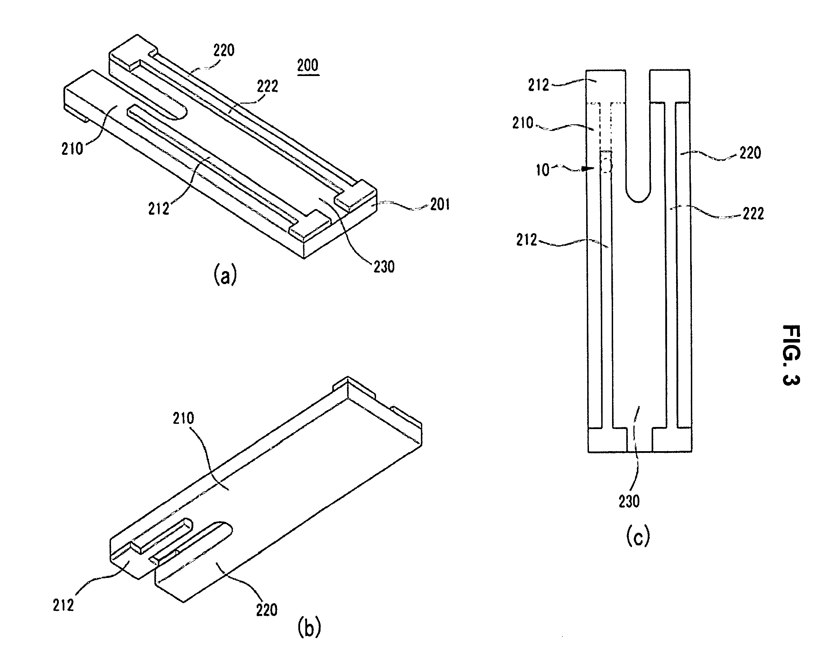

As shown in Table 3, the conductive mixed ink that forms the electrode 106 can be in completely close contact with the conductive film 104. Also, the conductive mixed ink has a small surface resistance, and thus less noise is generated. Hereinafter, referring to FIGS. 3A to 3C, the electrode connector 200 will be described in detail.

FIGS. 3A to 3C illustrate shapes of an electrode connector according to an embodiment of the invention. Specifically, FIGS. 3A to 3C are a perspective view, a bottom view, and a plan view of the electrode connector 200, respectively.

As shown in FIGS. 3A to 3C, the electrode connector 200 that is connected to the upper and lower electrodes 106a and 106b includes a Y-shaped substrate 201 including a first end portion 210, a second end portion 220, and a common end portion 230; a first interconnection 212 formed on the first end portion 210 and the common end portion 230; and a second interconnection 222 formed on the second end portion 220 and the common end portion 230.

Here, the Y-shaped substrate 201, for example, is a flexible substrate, and an example of such a flexible substrate may be an FPCB (Flexible Printed Circuit Board).

Also, the first interconnection 212 is connected to the upper electrode 106a and an electric signal input portion of the film speaker 100, and the second interconnection 222 is connected to the lower electrode 106b and the electric signal input portion of the film speaker 100.

Also, the first interconnection 212 is formed on a lower surface of the first end portion 210 and an upper surface of the common end portion 230, and the second interconnection 222 is formed on an upper surface of the second end portion 220 and the upper surface of the common end portion 230.

Here, the first interconnection 212 may be formed to extend from the upper surface of the common end portion 230 to the lower surface of the first end portion 210. In this case, one or more holes 10 are formed on the flexible substrate 201, and the first interconnections 212 formed on the upper surface of the common end portion 230 and the lower surface of the first end portion 210 are connected together through the corresponding hole 10.

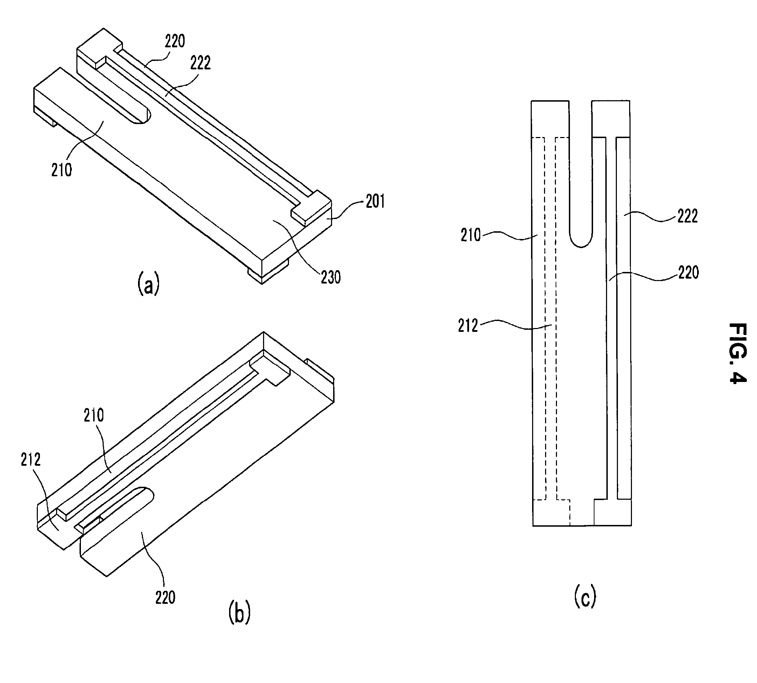

FIGS. 4A to 4C illustrate shapes of an electrode connector according to another embodiment of the invention. Specifically, FIGS. 4A to 4C are a perspective view, a bottom view, and a plan view of the electrode connector 200, respectively.

As shown in FIGS. 4A to 4C, the first interconnection 212 is formed on the lower surface of the first end portion 210 and the upper surface of the common end portion 230, and the second interconnection 222 is formed on the upper surface of the second end portion 220 and the upper surface of the common end portion 230.

Also, as shown in FIGS. 3A to 3C and 4A to 4C as described above, a coating layer may be formed on the upper and lower layers of the first end portion 210 and the second end portion 220. Through this, the first end portion 210 and the second end portion 220 come into close contact with the upper electrode 106a and the lower electrode 106b of the film speaker 100 to make an electric signal flow steadily. Here, in order to form the coating layer, a laminating film and so on may be used.

Also, adhesives are spread on at least one of the lower surface of the first end portion 210 and the upper surface of the second end portion 220, and thus the electrode connector 200 can be fixed to the upper electrode 106a and the lower electrode 106b of the film speaker 100 more effectively. In this case, an adhesive tape and so on may be used as the adhesives.

On the other hand, a reinforcement tape (not illustrated) may be formed on one side surface of the electrode connector 200. The reinforcement tape may have an adjustable thickness so as to be inserted into various kinds of connectors, and may be provided in a detachable form. Also, the reinforcement tape may serve as a support so that the electrode connector 200 is not deformed.

As described above, through the Y-shaped electrode connector 200 composed of FPCB or the like, which is not easily disconnected and has a high flexibility, the height of the components can be easily reduced, and the effects of reduction of the terminal process stage and the manufacturing cost can be heightened. Also, since the conventional soldering process is not required, harmful environments can be improved. Also, through one Y-shaped electrode connector 200, connection to the upper and lower portions of the piezoelectric film can be easily performed.

In an embodiment of the invention, FVDF (Poly Vinylidene Fluoride) film is used as the piezoelectric film. However, it is apparent to those skilled in the art diverse piezoelectric element films can be used instead.

In a preferred embodiment of the invention, the piezoelectric film is surface-processed in a corona method for the uniform surface process and the improvement of the adhesive power. The corona method (corona surface processing method) is a technique that improves the adhesive force of the surface of the film to be processed using a corona discharge technique. Typically, the PVDF film that is used as the piezoelectric film has the characteristics of very low adhesive property with a conductive polymer material, i.e. very low critical surface tension, due to its inherent chemical characteristics and low surface energy. If the piezoelectric film is corona-processed, particles having charges in corona collide with the film surface to oxidize the film surface. Accordingly, a polar group generated by surface oxidization, e.g. C=O, C-O-H, COOH, -COO-, -CO-, and the like, increases the surface energy of the film to improve the chemical attraction with the conductive polymer material, and thus the adhesion of the film is improved.

Also, in addition to the chemical polar group as described above, bridge structures are formed among the polymer molecules by the corona process, and thus the improvement of adhesion can be obtained. The corona surface process is typically performed in a manner that the piezoelectric film is positioned between both electrodes for generating the corona discharge, and the corona discharge is generated by supplying a constant power to the both electrodes. Since the corona surface process is performed using the known technology, further detailed description thereof will be omitted.

In the film speaker according to a preferred embodiment of the invention, the upper conductive film and the lower conductive film are made by mixing one or more selected from the group consisting of metal powder, carbon black, and carbon nano-tube to lower the resistance value.

In a preferred embodiment of the invention, the upper conductive film and the lower conductive film may be formed to have a specified resistance value in the range of 20Ω to 2,000Ω. Typically, the upper conductive film and the lower conductive film are made of conductive polymers such as polyaniline polythiophene, PEDOT, polypyrrole, PPV, and the like, and by combining the conductive polymers in diverse methods or adding a constant resistive material in addition to the conductive polymers, the resistance value of the upper conductive film and the lower conductive film can be diversely changed. More specifically, the upper conductive film and the lower conductive film are formed by coating a conductive polymer solution, in which the conductive polymer and the adhesive binder are mixed in a predetermined ratio, in accordance with the required resistance value. In this case, the conductive polymer solution is composed of 0.5 to 50 parts by weight of conductive polymer, 10 to 30 parts by weight of adhesive binder, and 20 to 89.5 parts by weight of solvent. In this case, the binder serves to improves the contact force and adhesive force between the piezoelectric film and the upper or lower conductive film, and includes one or more functional groups selected among acryl, urethane, ether, ester, epoxy, amide, imide, and the like.

Also, as the solvent, one selected among methyl alcohol, ethyl alcohol, isopropyl alcohol, normal butanol, water, toluene, xylene, 1-methyl-2-pyrrolidinone, chloroform, ethyl acetate, 2-methoxyethanol, ethylene glycol, polyethylene glycol, and dimethyl sulfoxide, or a combination thereof may be used.

In particular, in the case of producing a conductive polymer solution using a solvent such as ethylene glycol, polyethylene glycol, dimethyl suloxide, and the like, the resistance value of the conductive polymers can be lowered and thus it is effective in changing the resistance value. Also, in order to lower the resistance value, the conductive polymer solution may be made by mixing predetermined content of metal powder, carbon black, or carbon nano-tube.

In the film speaker according to a preferred embodiment of the invention, the resistance value of the upper conductive film and the lower conductive film is set to be in the range of 50Ω to 200Ω in the case where the film speaker is used as a speaker at 400Hz or lower.

In a preferred embodiment of the invention, the characteristics of sound pressure by frequency according to the change of the resistance value of the film speaker will be described in detail. Generally, when the sound pressure output from the speaker is about 72dB, sound of a good quality can be provided to a user. Accordingly, if the resistance value of the upper and lower conductive films is selected as a certain value within the range of 60Ω to 7000Ω, the film speaker according to an embodiment of the invention outputs the sound pressure of a predetermined level (i.e. the sound output characteristic to the extent that can be used as a speaker). Accordingly, the resistance value of the upper and lower conductive films can be adjusted so that a good output characteristic can be shown in an appropriate frequency band according to the use (i.e. low-pas band, intermediate-pass band, high-pass band, and the like) of the film speaker. That is, in the case of strengthening the output characteristics of 800Hz to 2,000Hz band, the conductive polymers and the resistance material, which constitute the upper and lower conductive films, are combined so that the resistance value of the upper and lower conductive films belongs to the range of 400Ω to 1500Ω. Also, in order to improve the response characteristic of the low-pass band frequency, the resistance value of the upper and lower conductive films may be set to be in the range of 50Ω to 200Ω. If the resistance value of the upper and lower conductive films is set to be in the range of 50Ω to 200Ω, a constant output is measured even in the frequency band of 400Hz or lower, whereas if the resistance value of the upper and lower conductive films is set to be 400Ω, it can be confirmed that no output is measured in the frequency band of lower than 100Hz. Accordingly, in the case of strengthening the output in the low-frequency band, it is preferable that the upper and lower conductive films are configured to have a predetermined resistance value within the range of 50Ω to 200Ω.

As described above, the present invention relates to an electrode connector and a film speaker including the electrode connector, and can be used in speaker-related industry fields.

Although preferred embodiments of the present invention have been described for illustrative purposes, those skilled in the art will appreciate that various modifications, additions and substitutions are possible, without departing from the scope and spirit of the invention as disclosed in the accompanying claims.

## Claims

1. An electrode connector for use in a film speaker, comprising:
a Y-shaped substrate including a first end portion, a second end portion, and a common end portion;
a first interconnection formed on the first end portion and the common end portion; and
a second interconnection formed on the second end portion and the common end portion;
wherein the first interconnection is connected to an upper electrode and an electric signal input portion of the film speaker, and
the second interconnection is connected to a lower electrode and the electric signal input portion of the film speaker.

2. The electrode connector according to claim 1, wherein the Y-shaped substrate is a flexible substrate.

3. The electrode connector according to claim 1, wherein the flexible substrate is a FPCB (Flexible Printed Circuit Board).

4. The electrode connector according to claim 2, wherein the first interconnection is formed on a lower surface of the first end portion and an upper surface of the common end portion, and the second interconnection is formed on an upper surface of the second end portion and the upper surface of the common end portion.

5. The electrode connector according to claim 4, wherein the first interconnection is formed to extend from the upper surface of the common end portion to the lower surface of the first end portion through a hole formed on the flexible substrate.

6. The electrode connector according to claim 1, wherein the first interconnection is formed on a lower surface of the first end portion and an upper surface of the common end portion, and the second interconnection is formed on an upper surface of the second end portion and the upper surface of the common end portion.

7. The electrode connector according to claim 1, wherein the first end portion and the second end portion are fixed to the lower electrode and the upper electrode of the film speaker by forming a coating layer on upper and lower layers of the first end portion and the second end portion.

8. The electrode connector according to claim 1, wherein adhesives are spread on at least one of a lower surface of the first end portion and an upper surface of the second end portion.

9. A film speaker comprising:
a piezoelectric film;
upper and lower conductive films formed on upper and lower surfaces of the piezoelectric film, respectively;
upper and lower electrodes formed to extend along edges of the upper and lower conductive films, respectively; and
a connector connected to the upper and lower electrodes;
wherein the connector includes:
a Y-shaped substrate including a first end portion, a second end portion, and a common end portion;
a first interconnection formed on the first end portion and the common end portion; and
a second interconnection formed on the second end portion and the common end portion;
wherein the first interconnection is connected to the upper electrode and an electric signal input portion of the film speaker, and
the second interconnection is connected to the lower electrode and the electric signal input portion of the film speaker.

10. The film speaker according to claim 9, wherein the upper and lower conductive films are formed on the inside of the piezoelectric film to be apart for a predetermined distance from an edge of the piezoelectric film.

11. The film speaker according to claim 9, wherein the piezoelectric film is formed of PVDF (Poly Vinylidene Flouride).

12. The film speaker according to claim 9, wherein the upper and lower conductive films are made by mixing one or more selected from the group consisting of metal powder, carbon black, and carbon nano-tube to lower a resistance value thereof.

13. The film speaker according to claim 9, wherein the resistance value of the upper and lower conductive films is set to be in the range of 50Ω to 200Ω in the case where the film speaker is used as a speaker at 400Hz or lower.
